(19) Europäisches Patentamt / European Patent Office / Office européen des brevets

(11) **EP 2 200 409 B1**

(12) **EUROPEAN PATENT SPECIFICATION**

(45) Date of publication and mention
of the grant of the patent:
**21.03.2012 Bulletin 2012/12**

(51) Int Cl.:
*H05K 1/03* *(2006.01)*    *H05K 3/46* *(2006.01)*
*H01L 23/15* *(2006.01)*

(21) Application number: **09178582.4**

(22) Date of filing: **10.12.2009**

(54) **Electronic part**

Elektronisches Teil

Pièce électronique

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **16.12.2008 JP 2008320033**

(43) Date of publication of application:
**23.06.2010 Bulletin 2010/25**

(73) Proprietor: **TDK Corporation
Tokyo 103-8272 (JP)**

(72) Inventors:
• **Kanada, Isao
Tokyo 103-8272 (JP)**
• **Kobuke, Hisashi
Tokyo 103-8272 (JP)**
• **Takahashi, Yusuke
Tokyo 103-8272 (JP)**
• **Miyauchi, Yasuharu
Tokyo 103-8272 (JP)**

(74) Representative: **Grünecker, Kinkeldey,
Stockmair & Schwanhäusser
Anwaltssozietät
Leopoldstrasse 4
80802 München (DE)**

(56) References cited:
WO-A1-2006/118003    WO-A1-2007/142112
US-A- 5 411 563    US-A1- 2003 113 554
US-A1- 2007 287 012

**Description**

BACKGROUND OF THE INTENTION

Field of the Invention

The present invention relates to an electronic part.

Related Background Art

As circuit boards for use in electronic devices there are known boards employing low temperature-firing ceramics obtained by firing a composition comprising a glass component and a filler component. In order to increase the strength of multilayer ceramic boards employing such boards, it has been attempted to satisfy a specific relationship between the thermal expansion coefficients of the surface layer section and inner layer section, while forming a structure with needle crystals deposited on the inner layer section (see Japanese Unexamined Patent Publication No. 2007-73 728). Patent document US 2007/0287012 (cf. the preamble of claim 1) relates to a laminate having a first external layer (1a, 1g) and a second internal layer (1b, 1f). Moreover, it is taught to have a first layer having a transverse rupture strength of 330 MPa (cf. sample no. 1 in table 1).
In a different embodiment, the reference teaches to have a thermal expansion coeffcieint for the second layer, higher than the thermal expansion coefficient for the first layer (cf. sample no. 12 in tables 1 and 2).
Patent document WO 2007/142112 discloses using a thermal expansion coefficient of the surface layer portions lower than the thermal expansion coefficient of the inner layer portion, thus generating compression stress in the surface layer portions in the course of a cooling step after the firing and improving the transverse strength of the multilayer ceramic substrate (cf. paragraph [0022] of the corresponding published European application EP 2026642).
Patent document (US 2003/113554) discloses a sintered glass ceramic product including at least three layers each of which is formed by a glass ceramic material, wherein the layers are stacked to be substantially symmetrical in a stacking direction and integrally sintered. Each of the outermost layers and the inner layer have thermal expansion coefficients alpha1 and alpha2 selected so that the relationship given by 0<alpha2-alpha1 <5 ppm is satisfied.
Patent document (US 5 411 563) discloses a method for preparing strengthened ceramic/glass substrates by laminating and sintering multiple layers of ceramic/glass precursory substrates having different thermal expansion coefficients, with the inner layer having higher thermal expansion coefficient and the outer layers having lower thermal expansion coefficient.
Patent document (WO 2006/118003) discloses a silicon nitride substrate, which has a high coefficient of thermal conductivity in the thickness-wise direction and has high fracture toughness in the thickness-wise direction, a silicon nitride wiring board using the silicon nitride substrate, which has low heat resistance and is highly reliable, and a semiconductor module using this silicon nitride wiring board, which has low heat resistance and is highly reliable. The silicon nitride substrate comprises ss-type silicon nitride and at least one rare earth element. The degree of in-plane orientation fa of the silicon nitride substrate is 0.4 to 0.8. In this case, the degree of in-plane orientation fa refers to the proportion of orientation in a plane perpendicular to the thickness-wise direction determined based on the proportion of each X-ray diffraction line intensity for a predetermined lattice plane of ss-type silicon nitride.

SUMMARY OF THE INVENTION

When the boards mentioned above are used as electronic parts for mounting in electronic devices, they preferably have high insulation resistance in addition to excellent strength. However, it has been observed that multilayer ceramic boards that simply have different thermal expansion coefficients for the surface layer section and inner layer section as described in Japanese Unexamined Patent Publication No. 2007-73728, still tend to be insufficient in terms of insulation resistance when applied as electronic parts.
The present invention has been accomplished in light of these circumstances, and its object is to provide an electronic part having excellent strength and high insulation resistance.
This is achieved by the teaching of claim 1.
As mentioned above, the electronic part of the invention has a construction comprising an inner layer section and outer layer sections having filler components dispersed in a glass component, while also satisfying the conditions that the thermal expansion coefficient of the inner layer section is larger than that of the outer layer sections and the inner layer section has a transverse strength above a prescribed level, whereby it exhibits excellent strength and, surprisingly, has high insulation resistance.
The difference between the thermal expansion coefficients of the inner layer section and outer layer sections in the electronic part of the invention is preferably in the range of 0.5-3 ppm/°C. Even more excellent insulation resistance will be obtained if the difference between the thermal expansion coefficients of the inner layer section and outer layer sections is within this range.

The inner layer section also preferably has a toughness index of at least $2.0$ MPa $\sqrt{m}$ . A construction satisfying these conditions will result in even more excellent insulation resistance.

According to the invention it is possible to provide an electronic part having excellent strength and high insulation resistance.

BRIEF DESCRIPTION OF THE DRAWINGS

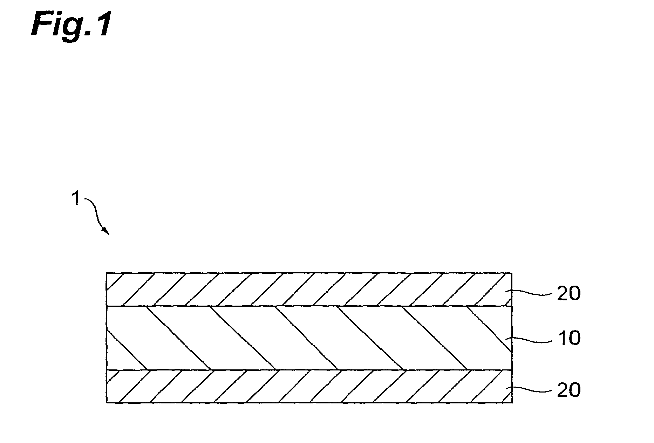

Fig. 1 is a schematic view of the cross-sectional structure of an electronic part according to a preferred embodiment.

DESCRIPTION OF THE PREFERRED EMBODIMENTS

Preferred embodiments of the invention will now be explained with reference to the accompanying drawings. Throughout the explanation of the drawings, corresponding elements will be referred to by like reference numerals and will be explained only once.

Fig. 1 is a schematic view of the cross-sectional structure of an electronic part according to a preferred embodiment. As shown in Fig. 1, the electronic part 1 has a construction comprising an inner layer section 10 and a pair of outer layer sections 20 formed covering both surfaces of the inner layer section 10.

The inner layer section 10 and outer layer sections 20 are each constructed of a material having a filler component dispersed in a glass component. The filler component content in the material is preferably 22-35 vol% with respect to the total of the glass component and filler component.

The glass component will be explained first.

As examples of glass components there may be mentioned two types: (1) amorphous glass-based materials and (2) crystallized glass-based materials. The (2) crystallized glass-based materials are materials having numerous fine crystals deposited in a glass component during heated firing, and they are also known as "glass ceramics".

More preferred as glass components among the aforementioned (1) amorphous glass-based materials and (2) crystallized glass-based materials are (2) crystallized glass-based materials. As (2) crystallized glass-based materials there may be used, for example, (i) glass components comprising $SiO_2$ $B_2O$, $Al_2O_3$ and alkaline earth metal oxides, and (ii) diopside crystal glass components comprising $SiO_2$, $CaO$, $MgO$, $Al_2O_3$ and $CuO$.

The $SiO_2$ content of a (i) glass component containing $SiO_2$, $B_2O_3$, $Al_2O_3$ and an alkaline earth metal oxide is preferably 46-60 wt% and more preferably 47-55 wt% based on the total weight of the glass component. A content of less than 46 wt% will tend to interfere with vitrification, while a content of greater than 60 wt% will tend to increase the melting point and render low-temperature sintering more difficult.

The $B_2O_3$ content is preferably 0.5-5 wt% and more preferably 1-3 wt% based on the total weight of the glass component. A content of greater than 5 wt% will tend to lower the humidity resistance, while a content of less than 0.5 wt% will tend to increase the vitrification temperature and lower the density.

The $Al_2O_3$ content is preferably 6-17.5 wt% and more preferably 7-16.5 wt% based on the total weight of the glass component. A content of less than 6 wt% will tend to slightly lower the strength, while a content of greater than 17.5 wt% will tend to interfere with vitrification. The alkaline earth metal oxide content is preferably 25-45 wt% and more preferably 30-40 wt% based on the total weight of the glass component.

As examples of alkaline earth metal oxides there may be mentioned MgO, CaO, BaO and SrO. These alkaline earth metal oxides may be used alone or in combinations of two or more types. It is preferred to use a combination of SrO and another alkaline earth metal oxide. Using a combination of SrO with one or more oxides selected from the group consisting of CaO, MgO and BaO can lower the viscosity of molten glass and enlarge the sintering temperature width, thus facilitating production.

The SrO content is preferably 60 wt% or greater and more preferably 80 wt% or greater based on the total weight of the alkaline earth metal oxides. If the content is less than 60 wt%, the difference in thermal expansion coefficients between the glass component and the filler described hereunder will be increased, tending to result in reduced strength of electronic parts.

The total content of CaO, MgO and BaO is preferably at least 1 wt% based on the total weight of the alkaline earth metal oxides. The contents of CaO and MgO are preferably both 0.2 wt% or greater and more preferably 0.5 wt% or greater, based on the total weight of the alkaline earth metal oxides. The CaO content is also preferably less than 10 wt% and the MgO content is preferably no greater than 4 wt%, based on the total weight of the alkaline earth metal oxides. If the CaO and MgO contents are above these limits, the thermal expansion coefficient will be too small and the strength of electronic parts will tend to be reduced, while it may also become difficult to control the degree of crystallinity of the glass. From the viewpoint of both facilitating production and obtaining strength for electronic parts, the total content of CaO and MgO with respect to the total weight of the alkaline earth metal oxides is preferably less than 10 wt%, and the CaO content is more preferably no greater than 5 wt%.

The BaO content is preferably no greater than 5 wt% with respect to the total weight of the alkaline earth metal oxides. A content of greater than 5 wt% will tend to increase the permittivity.

On the other hand, the (ii) diopside crystal glass components comprising $SiO_2$, CaO, MgO, $Al_2O_3$ and CuO are components that deposit diopside as the main crystal.

Of the diopside crystal glass components, $SiO_2$ is a glass network former and is a constituent component of diopside crystals. The $SiO_2$ content is preferably 40-65 wt% and more preferably 45-65 wt% with respect to the total amount of diopside crystal glass components. A content of less than 40 wt% will tend to make vitrification more difficult, while a content of greater than 65 wt% will tend to lower the density.

Of the diopside crystal glass components, CaO is a constituent component of diopside crystals, and its content is preferably 20-35 wt% and more preferably 25-30 wt% with respect to the total amount of diopside crystal glass components. A content of less than 20 wt% will tend to increase the dielectric loss, while a content of greater than 35 wt% will tend to make vitrification more difficult.

Of the diopside crystal glass components, MgO is also a constituent component of diopside crystals. The MgO content is preferably 11-30 wt% and more preferably 12-25 wt% with respect to the total amount of diopside crystal glass components. A content of less than 11 wt% will tend to make crystal deposition more difficult, while a content of greater than 30 wt% will tend to make vitrification more difficult.

Of the diopside crystal glass components, $Al_2O_3$ is a component that modulates the glass component crystallinity, and its content is preferably 0.5-10 wt% and more preferably 1-5 wt% with respect to the total amount of diopside crystal glass components. A content of less than 0.5 wt% will excessively increase the crystallinity, making glass molding more difficult, while a content of greater than 10 wt% will tend to make diopside crystal deposition more difficult.

Of the diopside crystal glass components, CuO is a component that donates electrons to Ag and inhibits its diffusion into the glass component. The CuO content is preferably 0.01-1.0 wt% with respect to the total amount of diopside crystal glass components. A content smaller than 0.01 wt% will tend to prevent the aforementioned effect from being adequately exhibited, while a content of greater than 1.0 wt% will tend to result in excessive dielectric loss.

Of the diopside crystal glass components, SrO, ZnO and $TiO_2$ are components added to facilitate vitrification. The content of each component is preferably 0-10 wt% and more preferably 0-5 wt% with respect to the total amount of diopside crystal glass components. If the content of each component is greater than 10 wt%, the crystallinity will be weakened and deposition of diopside will be reduced, thus tending to increase the dielectric loss.

Components other than those mentioned above may also be included as diopside crystal glass components in ranges that do not impair the properties such as dielectric loss.

Of the glass components (i) and (ii), the (ii) diopside crystal glass components are preferred from the viewpoint of obtaining more excellent strength.

The filler component will now be explained.

The filler component is a powder composed of a ceramic material, and it is dispersed in the glass component at the inner layer section 10 and outer layer sections 20. The form of the powder composing the filler component may be spherical, needle-like, laminar or the like without any particular restrictions, but from the viewpoint of improving the strength and especially transverse strength, it is preferably a laminar filler component. The mean particle size of the filler component is preferably about 1-8 $\mu$m.

As examples of filler components there may be mentioned alumina, magnesia, spinel, silica, mullite, forsterite, steatite, cordierite, strontium feldspar, quartz, zinc silicate, zirconia, titania and the like. Alumina is preferred among these from the viewpoint of improving the strength and especially the transverse strength. These fillers can be appropriately selected for use according to the properties to be exhibited by the inner layer section 10 and outer layer sections 20, and a combination of more than one type may also be used.

The filler component is preferably laminar alumina. Using laminar alumina as the filler component will significantly increase the transverse strength of the inner layer section 10 or outer layer sections 20 containing it. This can further improve the strength and insulation resistance of the electronic part 1, while also significantly reducing cracks during and after production of the electronic part 1. From the viewpoint of satisfactorily obtaining the effect, the laminar alumina preferably has a mean particle size in the range of 0.5-10 $\mu$m, a mean thickness in the range of 0.04-0.5 $\mu$m and a mean aspect ratio in the range of 10-100. The effect obtained when using laminar alumina as the filler component tends to be more notable when a combination of diopside crystallized glass and $SiO_2$-$B_2O_3$-$Al_2O_3$-SrO glass is used as the glass component.

As mentioned above, the inner layer section 10 and outer layer sections 20 of the electronic part 1 comprise the glass component and filler component described above, and the inner layer section 10 and outer layer sections 20 differ in the following properties.

Specifically, first the inner layer section 10 has a transverse strength of at least 330 MPa, more preferably at least 350 MPa and even more preferably at least 400 MPa. With such preferred transverse strength, it will be possible to obtain satisfactory strength and insulation resistance. While a higher transverse strength is preferred for the inner layer section 10, the upper limit is about 550 MPa at most, although this will differ depending on the combination of the glass component and filler component.

On the other hand, the transverse strength of the outer layer sections 20 is not particularly restricted and may be lower or higher than that of the inner layer section 10, but it is preferably as high as possible. This will tend to further improve the strength and insulating properties of the electronic part 10.

The transverse strength referred to here is the strength represented by the load at the point at which bending occurs when the load is gradually increased on the sample (breaking load). In the present specification, this is the value obtained in a 3-point bending test with a fulcrum distance of 15 mm and a cross head speed of 0.5 mm/min.

For the electronic part 1, the inner layer section 10 has a larger thermal expansion coefficient than the outer layer sections 20, and the difference is preferably 0.5-3 ppm/°C, more preferably 1-2 ppm/°C and even more preferably 1.5-2 ppm/°C. More excellent insulation resistance can be obtained if the difference in thermal expansion coefficients is further within the preferred range. The thermal expansion coefficient is the value obtained by measuring the dimensional change between 50-350°C by TMA.

Also, the inner layer section 10 preferably has a toughness index of at least 2.0 MPa√m and more preferably at least 2.5 MPa√m. Such a toughness index will provide even greater strength and further improved insulation resistance. While a higher toughness index is preferred, the upper limit will generally be about 3.5 MPa√m. The toughness index referred to here is the value determined by the IF method of JIS R1607.

The inner layer section 10 in the electronic part 1 preferably has a larger Young's modulus than the outer layer sections 20. Specifically, the inner layer section 10 preferably has a Young's modulus that is at least 1.2 times and more preferably a Young's modulus that is at least 1.4 times that of the outer layer sections 20.

The inner layer section 10 and outer layer sections 20 in the electronic part 1 have the properties and relationship described above, but these properties can be modified by appropriately changing the type of glass component or filler component composing the inner layer section 10 and outer layer sections 20, or the filler component content. Specifically, the constituent materials of the inner layer section 10 and outer layer sections 20 may be appropriately selected from among materials with different glass component and filler component types and filler component contents so that the properties and relationship mentioned above are satisfied in the electronic part 1.

The properties of the inner layer section 10 and outer layer sections 20 described above may be measured while they are in the electronic part 1, but this is usually difficult in practice. In such cases, the inner layer section 10 or outer layer section 20 properties can be determined by forming a different sample (evaluation sample) using the constituent materials and conducting measurement using the obtained sample. The constituent materials suitable for the inner layer section 10 and outer layer sections 20 in the electronic part 1 can be determined based on the properties obtained for such an evaluation sample.

In the electronic part 1, the inner layer section 10 preferably has a thickness of at least 1/2, more preferably a thickness of at least 2/3 and even more preferably a thickness of at least 4/5 of the entire thickness of the electronic part 1 (the total thickness of the inner layer section 10 and outer layer sections 20). An inner layer section 10 having such a thickness will result in even more excellent strength and satisfactory insulation resistance. The outer layer sections 20 are provided sandwiching the inner layer section 10, and in order to obtain stable properties, the pair of outer layer sections 20 sandwiching the inner layer section preferably have roughly the same thickness from the viewpoint of reducing warping or deformation.

An electronic part 1 having such a construction will exhibit excellent strength against breakage and the like, firstly because it has a construction in which the inner layer section 10 is covered by the outer layer sections 20. In addition, the electronic part 1 can exhibit high insulation resistance because the inner layer section 10 has a specified transverse strength of at least 330 MPa and the inner layer section 10 has a larger thermal expansion coefficient than the outer layer sections 20.

In addition to these properties, the electronic part 1 also has very low cracking during production. This is presumably because the inner layer section 10 has a larger thermal expansion coefficient than the outer layer sections 20, and therefore the outer layer sections 20, despite their low heat shrinkage, shrink more than normally as they are stretched by the large heat shrinkage of the inner layer section 10 during cooling after heat treatment such as sintering during production of the electronic part 1, and as a result compression stress is applied onto the outer layer sections 20. When the Young's modulus of the inner layer section 10 is relatively large, the shrinkage force on the outer layer section 20 is further increased, such that compression stress is effectively exerted by the outer layer sections 20. Such compression stress of the outer layer sections 20 prevents propagation of crazing and the like in the outer layer sections 20 even when the electronic part 1 is cut during production, and therefore the electronic part 1 is rendered resistant to cracking. If the inner layer section 10 has a transverse strength and toughness above a specified level, in addition to the prescribed thermal expansion coefficient difference between the inner layer section 10 and outer layer sections 20, breakage at undesirable sections caused by external force during cutting and the like will be inhibited, and the electronic part 1 will be rendered further resistant to cracking.

An electronic part 1 having such a construction can be obtained by the following production process, as an example.

First, starting materials for the glass component and filler component to form the inner layer section 10 and outer layer sections 20 are prepared. These are weighed out for the prescribed volume ratios in the inner layer section 10 or outer layer sections 20 and mixed with a ball mill or the like, with addition of a dispersing agent, plasticizer or solvent as necessary, to prepare a paste for molding of the inner layer section 10 and pastes for molding of the outer layer sections 20. Next, the pastes are coated onto a base such as a PET film using doctor blading or the like to obtain an inner layer section 10-forming sheet and outer layer section 20-forming sheets composed of each paste. The bases may be removed after the sheets have been formed.

The inner layer section 10-forming sheet is sandwiched between the outer layer section 20-forming sheets, and the stack is hot pressed, for example, to obtain a laminated body. The inner layer section 10-forming sheet and outer layer section 20-forming sheets may each be used as a stack of multiple sheets to obtain the prescribed thickness for the electronic part 1.

The laminated body is then fired, after being first subjected to binder removal treatment if necessary to remove the solvent, etc. in each sheet. The binder removal treatment may be carried out by heating the laminated body at or above the decomposition temperature of the solvent. The firing may be conducted by holding the laminated body for about 5-500 minutes at preferably no higher than 1000°C, more preferably 800-1000°C and even more preferably 850-900°C. The firing atmosphere may be an oxidizing atmosphere or neutral atmosphere, and specifically it may be air, oxygen, nitrogen or a mixed gas atmosphere of these gases.

The fired laminated body may then be worked by cutting or the like as necessary to obtain an electronic part 1 having the construction described above. As mentioned above, the electronic part 1 obtained in this manner comprises an inner layer section 10 and outer layer sections 20 having the specified properties and relationship, and therefore it has excellent strength and insulation resistance, as well as very low occurrence of cracks during working such as cutting.

During production of the electronic part 1 it is not absolutely necessary to obtain the laminated body by lamination after formation of the sheets as described above, and for example, each paste may be coated in order onto a prescribed base to obtain the laminated body. When a conductor pattern-formed electronic part is to be obtained for construction of circuits and the like on the surface, the conductor pattern may first be formed on the laminated body and the entire body then fired. Also, a plurality of laminated bodies with such conductor patterns may be layered and fired to produce a multilayer electronic part (multilayer board).

[Examples]

The present invention will now be explained in greater detail through the following examples, with the understanding that these examples are in no way limitative on the invention.

[Formation of inner layer section and outer layer section-forming sheets]

First, as glass component starting materials there were prepared diopside glass and $SiO_2$-$B_2O_3$-$Al_2O_3$-SrO glass, and as filler component starting materials there were prepared forsterite, alumina, laminar aluminas 1-4, mullite and cordierite. The laminar aluminas 1-4 had the properties shown in Table 1.

[Table 1]

|  | Laminar alumina 1 | Laminar alumina 2 | Laminar alumina 3 | Laminar alumina 4 |
|---|---|---|---|---|
| Mean particle size ($\mu$m) | 5.0 | 10.0 | 7.0 | 5.0 |
| Mean thickness ($\mu$m) | 0.07 | 0.30 | 0.10 | 0.20 |
| Mean aspect ratio | 71 | 33 | 70 | 25 |

These were weighed out to the glass component and filler component combinations and volume ratios shown in Table 2, and then dispersing agents, plasticizers, lacquers and solvents were added and the mixtures were mixed with a ball mill to prepare pastes. After degassing the pastes, they were each coated onto a PET film by doctor blading and the PET film was released to obtain sheets A-M composed of each paste.

[Evaluation of properties of sintered compacts obtained using each sheet A-M alone]

The obtained sheets A-M were laminated in a prescribed number and then pressed, cut by dicing and fired at 900°C, to form evaluation samples of fixed thickness. When sheets F and G were used, a layer made of tridymite (constraint layer) was formed on the outermost layer during lamination and the constraint layer was removed after firing. The number of laminated sheets was appropriately changed so that the thickness of each sample was the same.
The properties of each obtained sample were measured in the manner described below. The measured properties correspond to the properties of the inner layer section or outer layer section formed from each sheet, in the electronic parts also described below. The obtained results are summarized in Table 2.

(1) Linear expansion coefficient: The dimensional change at 50-350°C for each sample was measured by TMA.
(2) Transverse strength and Young's modulus: Each sample, having dimensions of approximately 25 mm length × 3.3 mm width × 0.5 mm height was subjected to a load under conditions with a fulcrum distance of 15 mm and a cross head speed of 0.5 mm/min, and the transverse strength was calculated from the load at the breaking point and the dimensions of the sample, while the Young's modulus was calculated from the slope of the load with respect to displacement and the dimensions of the sample. The values in Table 2 are the average values of the results measured for 30 samples.
(3) Toughness index: This was determined by the IF method of JIS R1607. Specifically, measurement was conducted at 5 locations on a mirror surface-finished sample with a thickness of 0.5 mm, using a 14.7 N measuring load, and the mean value was recorded as the toughness index.

[Table 2]

| Sheet | Filler component | Filler component amount | Glass component | $\alpha$ | Young's modulus | Toughness index | Transverse strength |
|---|---|---|---|---|---|---|---|
| | Type | vol% | Type | ppm/°C | GPa | Mpa√m | MPa |
| A | Forsterite | 20 | Diopside | 9.5 | 122 | 1.9 | 247 |
| B | Alumina | 20 | Diopside | 7.9 | 150 | 2.3 | 260 |
| C | Alumina | 30 | Diopside | 8.0 | 175 | 2.5 | 336 |
| D | Laminar alumina 1 | 20 | Diopside | 7.9 | 150 | 2.7 | 400 |
| E | Laminar alumina 1 | 30 | Diopside | 7.7 | 170 | 3.2 | 491 |
| F | Mullite | 30 | Diopside | 6.5 | 113 | 2.0 | 289 |
| G | Mullite | 35 | Diopside | 5.9 | 115 | 2.1 | 288 |
| H | Cordierite | 30 | Diopside | 6.4 | 112 | 1.9 | 252 |
| I | Laminar alumina 2 | 30 | Diopside | 7.8 | 175 | 2.7 | 410 |
| J | Laminar alumina 3 | 30 | Diopside | 7.7 | 171 | 2.9 | 478 |
| K | Laminar alumina 4 | 30 | Diopside | 7.8 | 174 | 2.7 | 422 |
| L | Laminar alumina 1 | 30 | $SiO_2$-$B_2O_3$-$Al_2O_3$-SrO | 6.3 | 126 | 2.5 | 375 |
| M | Mullite | 30 | $SiO_2$-$B_2O_3$-$Al_2O_3$-SrO | 4.9 | 100 | 1.8 | 230 |

[Fabrication of electronic part]

An inner layer and outer layers were selected from the sheets A-M and the outer layer sheets were layered above and below the inner layer sheet to obtain a laminated body. The combinations of inner layer and outer layer sheets are listed in Table 3. The inner layer and outer layer sheets were used in a prescribed number to obtain the prescribed thickness after firing. The outer layer sheets were used at the same thickness on the upper and lower sides.

Each of the obtained laminated bodies was pressed, cut by dicing and then fired at 900°C, to form electronic part samples (samples 1-29) each having dimensions of approximately 25 mm length $\times$ 3.3 mm width $\times$ 0.5 mm height.

For measurement of the electrical resistance (IR) of each electronic part, combinations of the same sheets as samples 1-29 were used to fabricate separate electronic parts to function as monolayer condenser chips. Specifically, first Ag paste was used for printing of a condenser electrode on the inner layer sheet to produce an electrode-bearing inner layer sheet. Two electrode-bearing inner layer sheets were then layered in combination with an inner layer sheet with no electrode formed thereon, and then the outer layer sheets were laminated above and below. The section sandwiched between the pair of condenser electrodes was positioned roughly at the center in the direction of lamination. The distance between the condenser electrodes was approximately 40 $\mu$m after firing. The inner layer and outer layer sheets were used with thicknesses and numbers of sheets so that the total thickness after firing was approximately 0.5 mm and the thickness ratios of the inner layer sections and outer layer sections were the ratios shown in Table 3. A constraint layer made of tridymite was then further provided above and below the obtained laminated body.

Each laminated body obtained in this manner was fired at 900°C, and after removing the constraint layers, was cut by dicing. After then coating a Ag paste onto the cut surface where the condenser electrode lead sections were exposed, it was baked to form terminal electrodes. A Ni layer and a Sn layer were formed in that order by electroplating on the terminal electrodes to obtain a monolayer condenser chip.

[Evaluation of electronic parts]

The transverse strength and insulation resistance (IR) of each of the electronic part samples 1-29 obtained as described above were measured. The results are shown in Table 3. Table 3 shows the inner layer section thickness ratio (inner layer ratio) with the thickness of the entire electronic part as 1, the properties obtained using only the sheets used for the inner layer sections and outer layer sections, and the difference in the thermal expansion coefficients of the inner layer section and outer layer sections ($\alpha$ difference).

(1) Transverse strength: The transverse strength was measured for samples 1-29 by the same method described above.

(2) Insulation resistance (IR): A digital superinsulating/microammeter was used to measure the resistance value at 50 V, 15 seconds, for the monolayer condenser chip corresponding to each sample 1-29. Measurement was conducted for 21 of each of the condenser chips, and the number among the 21 samples judged to be defective was counted, where a resistance value of less than $10^6$ $\Omega$ was defined as defective. A smaller defective number represented more excellent insulation resistance.

[Table 3]

| Sample No. | Sheets | | Inner layer ratio | $\alpha$Difference ppm/°C | Inner layer section | | | Outer layer sections | | Electronic parts | |
|---|---|---|---|---|---|---|---|---|---|---|---|
| | Inner layer section | Outer layer sections | | | Toughness index MPa√m | Young's modulus GPa | Transverse strength MPa | Young's modulus GPa | Transverse strength MPa | Transverse strength MPa | Number of IR defects (out of 21) |
| 1 | A | C | 0.8 | 1.5 | 1.9 | 122 | 247 | 175 | 336 | 412 | 9 |
| 2 | B | F | 0.8 | 1.4 | 2.3 | 150 | 260 | 113 | 289 | 352 | 2 |
| 3 | C | F | 0.8 | 1.5 | 2.5 | 175 | 336 | 113 | 289 | 412 | 0 |
| 4 | D | F | 0.8 | 1.4 | 2.7 | 150 | 400 | 113 | 289 | 525 | 0 |
| 5 | E | F | 0.8 | 1.2 | 3.2 | 170 | 491 | 113 | 289 | 575 | 0 |
| 6 | E | G | 0.8 | 1.8 | 3.2 | 170 | 491 | 115 | 288 | 604 | 0 |
| 7 | E | H | 0.8 | 1.7 | 3.2 | 170 | 491 | 112 | 252 | 508 | 0 |
| 8 | A | C | 0.4 | 1.5 | 1.9 | 122 | 247 | 175 | 336 | 378 | 21 |
| 9 | A | C | 0.5 | 1.5 | 1.9 | 122 | 247 | 175 | 336 | 392 | 20 |
| 10 | A | C | 0.7 | 1.5 | 1.9 | 122 | 247 | 175 | 336 | 400 | 11 |
| 11 | A | C | 0.9 | 1.5 | 1.9 | 122 | 247 | 175 | 336 | 378 | 6 |
| 12 | B | F | 0.4 | 1.4 | 2.3 | 150 | 260 | 113 | 289 | 365 | 3 |
| 13 | B | F | 0.5 | 1.4 | 2.3 | 150 | 260 | 113 | 289 | 377 | 2 |
| 14 | B | F | 0.7 | 1.4 | 2.3 | 150 | 260 | 113 | 289 | 355 | 0 |
| 15 | B | F | 0.9 | 1.4 | 2.3 | 150 | 260 | 113 | 289 | 354 | 1 |
| 16 | C | F | 0.4 | 1.5 | 2.5 | 175 | 336 | 113 | 289 | 381 | 1 |
| 17 | C | F | 0.5 | 1.5 | 2.5 | 175 | 336 | 113 | 289 | 399 | 0 |
| 18 | C | F | 0.7 | 1.5 | 2.5 | 175 | 336 | 113 | 289 | 384 | 0 |
| 19 | C | F | 0.9 | 1.5 | 2.5 | 175 | 336 | 113 | 289 | 397 | 0 |
| 20 | E | G | 0.4 | 1.8 | 3.2 | 170 | 491 | 115 | 288 | 334 | 0 |
| 21 | E | G | 0.5 | 1.8 | 3.2 | 170 | 491 | 115 | 288 | 447 | 0 |
| 22 | E | G | 0.7 | 1.8 | 3.2 | 170 | 491 | 115 | 288 | 538 | 0 |

(continued)

| Sample No. | Sheets | | Inner layer ratio | αDifference ppm/°C | Inner layer section | | | Outer layer sections | | Electronic parts | |
|---|---|---|---|---|---|---|---|---|---|---|---|
| | Inner layer section | Outer layer sections | | | Toughness index MPa√m | Young's modulus GPa | Transverse strength MPa | Young's modulus GPa | Transverse strength MPa | Transverse strength MPa | Number of IR defects (out of 21) |
| 23 | E | G | 0.9 | 1.8 | 3.2 | 170 | 491 | 115 | 288 | 595 | 0 |
| 24 | E | C | 0.8 | 0.0 | 3.2 | 170 | 491 | 175 | 336 | 340 | 0 |
| 25 | E | A | 0.8 | -1.5 | 3.2 | 170 | 491 | 122 | 247 | 122 | 0 |
| 26 | I | G | 0.8 | 1.9 | 2.7 | 175 | 410 | 115 | 288 | 481 | 0 |
| 27 | J | G | 0.8 | 1.8 | 2.9 | 171 | 478 | 115 | 288 | 560 | 0 |
| 28 | K | G | 0.8 | 1.9 | 2.7 | 174 | 422 | 115 | 288 | 495 | 0 |
| 29 | L | M | 0.8 | 1.4 | 2.5 | 126 | 375 | 100 | 230 | 410 0 | 0 |

Of samples 1-29, the samples 3-7, 16-23 and 26-29 corresponded to examples since they satisfied all of the conditions of the invention, while the other samples corresponded to comparative examples since they had inner layer section transverse strengths of less than 330 MPa, or the thermal expansion coefficients of the outer layer sections were larger than that of the inner layer section. The samples corresponding to examples had both excellent strength and insulation resistance, whereas the samples corresponding to comparative examples were inadequate in either or both insulation resistance and strength.

**Claims**

1.   An electronic part comprising an inner layer section (10) and outer layer sections(20) formed as surface layer sections covering the surface of the inner layer section, wherein
    the inner layer section and outer layer sections have a construction with a filler component dispersed in a glass component,
    the transverse strength of the inner layer section is at least 330 MPa, the transverse strength being measured in a 3-point bending test, and
    **characterized in that**
    the inner layer section has a thermal expansion coefficient larger than that of the outer layer sections and
    the inner layer section has a larger Young's modulus than the outer layer sections.

2.   An electronic part according to claim 1, **characterized in that** the difference between the thermal expansion coefficients of the inner layer section and outer layer sections is in the range of 0.5-3 ppm/[deg.]C.

3.   An electronic part according to claim 1, **characterized in that** the toughness index of the inner layer section is at least 2.0 MPa[square root of]m.

**Patentansprüche**

1.   Elektronisches Teil, das einen Innenschicht-Abschnitt (10) und Außenschicht-Abschnitte (20) umfasst, die als Oberflächenschicht-Abschnitte ausgebildet sind, die die Oberfläche des Innenschicht-Abschnitts abdecken, wobei
    der Innenschicht-Abschnitt und die Außenschicht-Abschnitte eine Konstruktion haben, bei der eine Füllkomponente in einer Glaskomponente dispergiert ist,
    die Biegefestigkeit des Innenschicht-Abschnitts wenigstens 330 MPa beträgt und die Biegefestigkeit in einem 3-Punkt-Biegetest gemessen wird, und
    **dadurch gekennzeichnet, dass**
    der Innenschicht-Abschnitt einen Wärmeausdehnungskoeffizienten hat, der größer ist als der der Außenschicht-Abschnitte, und
    der Innenschicht-Abschnitt einen größeren Youngschen Modul hat als die Außenschicht-Abschnitte.

2.   Elektronisches Teil nach Anspruch 1, **dadurch gekennzeichnet, dass** die Differenz zwischen den Wärmeausdehnungskoeffizienten des Innenschicht-Abschnitts und der Außenschicht-Abschnitte im Bereich von 0,5 - 3 ppm/°C liegt.

3.   Elektronisches Teil nach Anspruch 1, **dadurch gekennzeichnet, dass** der Zähigkeitsindex des Innenschicht-Abschnitts wenigstens 2,0 MPa $\sqrt[2]{m}$ beträgt.

**Revendications**

1.   Pièce électronique comprenant une section de couche intérieure (10) et des sections de couches extérieures (20) formées comme sections de couches de surface couvrant la surface de la section de couche intérieure, étant précisé que la section de couche intérieure et les sections de couches extérieures ont une construction avec un composant de charge dispersé dans un composant de verre,
    que la résistance à la flexion transversale de la section de couche intérieure est d'au moins 330 MPa, la résistance à la flexion transversale étant mesurée lors d'un test de flexion en 3 points, et
    **caractérisée en ce que** la section de couche intérieure a un coefficient de dilatation thermique supérieur à celui des sections de couches extérieures, et

**en ce que** la section de couche intérieure a un module de Young supérieur à celui des sections de couches extérieures.

2. Pièce électronique selon la revendication 1, **caractérisée en ce que** la différence entre les coefficients de dilatation thermique de la section de couche intérieure et des sections de couches extérieures est de l'ordre de 0,5-3 ppm/ [deg] C.

3. Pièce électronique selon la revendication 1, **caractérisée en ce que** l'indice de résistance de la section de couche intérieure est d'au moins 2,0 MPa[racine carrée de] m.

**Fig.1**

**EP 2 200 409 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007073728 A
- US 20070287012 A
- WO 2007142112 A
- EP 2026642 A
- US 2003113554 A
- US 5411563 A
- WO 2006118003 A